# EUROPEAN PATENT APPLICATION

(11) **EP 1 041 690 A1**
(43) Date of publication of application: **04.10.2000**
(21) Application number: 99302415.7
(22) Date of filing: 29.03.1999
(51) Int. Cl.: H01S 5/026, H01S 5/183

(54) **Light transmitting/receiving module system using surface emitting lasers**

(71) Applicant: SAMSUNG ELECTRONICS CO., LTD., Suwon-City, Kyungki-do (KR)
(72) Inventor: Shin, Hyun-kuk, Suwon-city, Kyungki-do 442-470 (KR)
(74) Representative: Chugg, David John

(57) **Abstract**

A light transmitting/receiving module system includes a first transmitting/receiving module (10) having a first surface emitting laser (20) for emitting light in a direction in which semiconductor material layers are stacked and a first photodetector (50) integrally formed on the first surface emitting laser (20), and a second transmitting/receiving module (15) having a second surface emitting laser (60) for emitting light in a direction in which semiconductor material layers are stacked and a second photodetector (70) integrally formed on the second surface emitting laser (60), wherein a first light emitted from the first surface emitting laser (20) is detected by the second photodetector (70) and a second light emitted from the second surface emitting laser (60) is detected by the first photodetector (50) so that the first and second lights are transmitted through a single path (13).

## Description

The present invention relates to a light transmitting/receiving module system using surface emitting lasers.

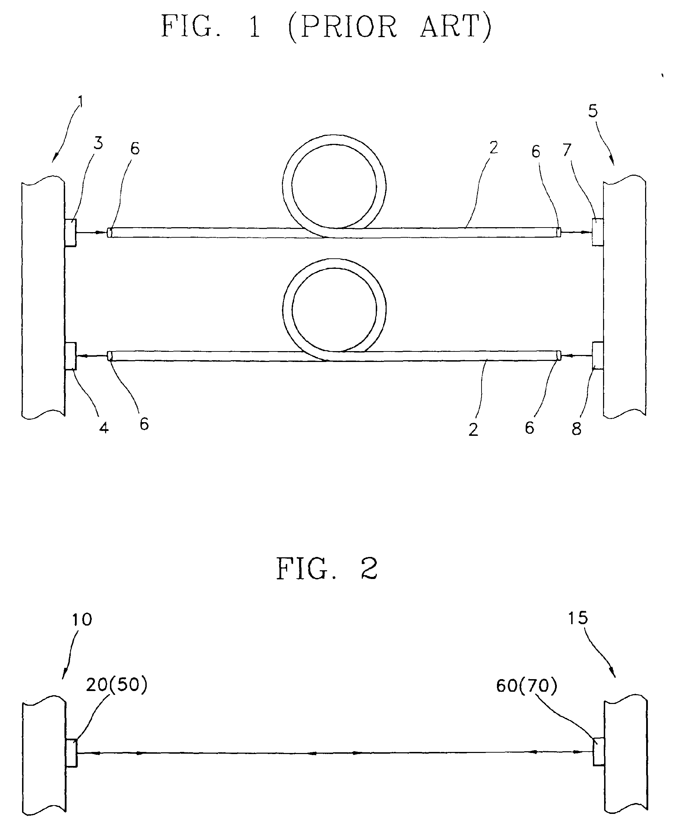

A general example of signal transmission using a laser is illustrated in Figure 1, in which the signal transmission between a first transmitting/receiving module 1 and a second transmitting/receiving module 5 is achieved by detecting an optical signal output from a first light source 3 using a first photodetector 7 and detecting an optical signal output from a second light source 8 using a second photodetector 4.

An optical fibre 2 is installed between the first light source 3 and the first photodetector 7 and between the second light source 8 and the second photodetector 4 and light is transmitted through the optical fibre 2. A focusing lens 6 is attached to both ends of the optical fibre 2.

In the first and second transmitting/receiving modules 1 and 5, edge emitting lasers or emitting diodes are employed as the first and second light sources 3 and 8. The light emitted from the first light source 3 is an optical signal which is an appropriately modulated data signal to be transmitted. The optical signal is transmitted through the optical fibre 2, detected by the first photodetector 7 to be converted into a current signal and then demodulated into an original signal through an amplifying circuit, etc.

In the above-described conventional light transmitting/receiving module system, for signal transmission between two modules, each module requires two channels, that is, a transmitting channel and a receiving channel. Thus, the structure of the conventional light transmitting/receiving module system is complex. Also, since many components are necessary, it is not easy to fabricate the conventional transmitting/receiving modules. Further, in the case of multiple-channel data transmission, more transmitting/receiving channels are necessary. Thus, the problems, that is, complex structure and difficult fabrication, becomes more severe.

With a view to solve or reduce the above problems, it is an aim of preferred embodiments of the present invention to provide a light transmitting/receiving module with a simple structure by using a single path for transmission and reception of a signal.

According to a first aspect of the invention, there is provided a light transmitting/receiving module system including a first transmitting/receiving module having a first surface emitting laser for emitting light in a direction in which semiconductor material layers are stacked and a first photodetector integrally formed on the first surface emitting laser, and a second transmitting/receiving module having a second surface emitting laser for emitting light in a direction in which semiconductor material layers are stacked and a second photodetector integrally formed on the second surface emitting laser, wherein a first light emitted from the first surface emitting laser is detected by the second photodetector and a second light emitted from the second surface emitting laser is detected by the first photodetector so that the first and second lights are transmitted through a single path.

Here, the first and second photodetectors preferably monitor the amount of the light emitted from the first and second surface emitting lasers.

Also preferably, each of the first and second surface photodetectors includes a first semiconductor material layer stacked on the second reflector layer, an absorption layer stacked on the first semiconductor material layer, for absorbing incident light, a second semiconductor material layer stacked on the absorption layer, and a third electrode formed on a part of the upper surface of the second semiconductor material layer, for outputting a detection signal.

Each of the first and second surface photodetectors preferably comprises: a first semiconductor material layer stacked on the second reflector layer; an absorption layer stacked on the first semiconductor material layer, for absorbing incident light; a second semiconductor material layer stacked on the absorption layer; and a third electrode formed on a part of the upper surface of the second semiconductor material layer, for outputting a detection signal.

The light transmitting/receiving module system preferably, further comprises an optical fibre installed along an optical path between the first and second transmitting/receiving modules, for transmitting light.

According to another aspect of the present invention, there is provided a light transmitting/receiving module system including a plurality of first transmitting/receiving modules each having a first surface emitting laser for emitting light in a direction in which semiconductor material layers are stacked and a first photodetector integrally formed on the first surface emitting laser, and a plurality of second transmitting/receiving modules each having a second surface emitting laser for emitting light in a direction in which semiconductor material layers are stacked and a second photodetector integrally formed on the second surface emitting laser, wherein a first light emitted from the first surface emitting laser is detected by the second photodetector and a second light emitted from the second surface emitting laser is detected by the first photodetector so that the first and second lights are transmitted through a single path.

The first and second surface emitting lasers of the plurality of the first and second transmitting/receiving modules are preferably integrally formed on a single substrate in an array format.

The first and second photodetectors preferably monitor the amount of the light emitted from the first and second surface emitting lasers.

Each of the first and second surface emitting lasers preferably comprise: a substrate; a first reflector layer formed on the upper surface of the substrate; an active layer formed on the upper surface of the first reflector layer, for generating light; a second reflector layer formed on the upper surface of the active layer, for reflecting the light generated at the active layer to resonate the light together with the first reflector layer; and first and second electrodes formed on the lower surface of the substrate and on a part of the upper surface of the second reflector layer.

Each of the first and second surface photodetectors preferably comprises: a first semiconductor material layer stacked on the second reflector layer; an absorption layer stacked on the first semiconductor material layer, for absorbing incident light; a second semiconductor material layer stacked on the absorption layer; and a third electrode formed on a part of the upper surface of the second semiconductor material layer, for outputting a detection signal.

A plurality of optical fibres are preferably installed along an optical path between the first and second transmitting/receiving modules, for transmitting light.

For a better understanding of the invention, and to show how embodiments of the same may be carried into effect, reference will now be made, by way of example, to the accompanying diagrammatic drawings, in which:
Figure 1 schematically illustrates a conventional light transmitting/receiving module system;
Figure 2 schematically illustrates a light transmitting/receiving module system according to an embodiment of the present invention;
Figure 3 is a schematic cross section of a photodetector and a surface emitting laser employed in the light transmitting/receiving module system shown in Figure 2;
Figure 4 illustrates an example of an optical fibre employed in the light transmitting/receiving module system shown in Figure 2;
Figure 5 schematically illustrates a light transmitting/receiving module system according to another embodiment of the present invention; and
Figure 6 illustrates an example of an optical fibre employed in the light transmitting/receiving module system shown in Figure 5;

Referring to Figure 2, a light transmitting/receiving module system using surface emitting lasers according to a preferred embodiment of the present invention includes a first transmitting/receiving module 10 having a first surface emitting laser 20 and a first photodetector 50 integrally formed on the first surface emitting laser 20, and a second transmitting/receiving module 15 having a second surface emitting laser 60 and a second photodetector 70 integrally formed on the second surface emitting laser 60.

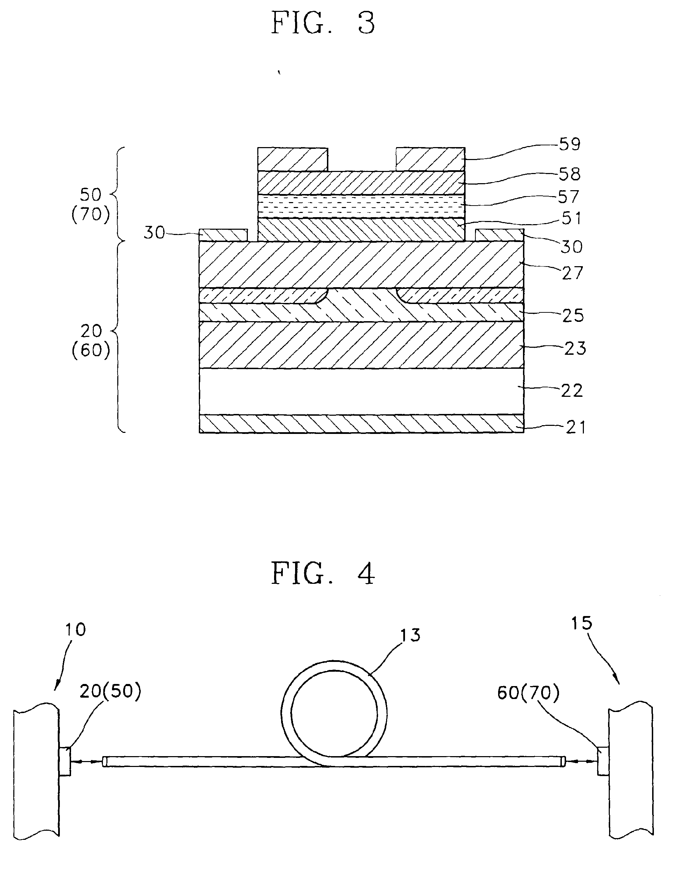

The first and second surface emitting lasers 20 and 60 emit light in a direction in which semiconductor material layers are stacked. As shown in Figure 3, each of the first and second surface emitting lasers 20 and 60 includes a substrate 22, a first reflector layer 23, an active layer 25 and a second reflector layer 27, which are sequentially stacked on the substrate 22, and first and second electrodes 21 and 30 formed on the lower surface of the substrate 22 and on a part of the upper surface of the second reflector layer 27.

The first and second reflector layers 23 and 27 are formed by alternately stacking a semiconductor compound and allows a light having a specific wavelength by resonating the light generated from the active layer 25. Here, preferably, the first reflector layer 23 is an n-type layer and the second reflector layer 27 is a p-type layer. The reflection coefficients of the first and second reflector layers 23 and 27 depend on the number of stacks of the semiconductor compound.

Thus, if a forward bias is applied to the first and second electrodes 21 and 30, the current flows through the active layer 25 and lights are generated at the active layer 25 due to combination of electrons and holes. Among the generated lights, only the light having a wavelength suitable for the resonance conditions by the first and second reflector layers 23 and 27 is amplified to then be transmitted through the first or second reflector 23 or 27 and is emitted from the lower or upper surface of the first or second surface emitting laser 20 or 60.

Here, the light emitted from the first or second surface emitting laser 20 or 60 is modulated by a driving circuit (not shown) to correspond to a data signal transmitted between the first and second transmitting/receiving modules 10 and 15.

Also, each of the first and second photodetectors 50 and 70 includes a first semiconductor material layer 51, an absorption layer 57 and a second semiconductor material layer 58, sequentially stacked on the second reflector layer 27 of the first and second surface emitting lasers 20 and 60, and a third electrode 59 formed on a part of the upper surface of the second semiconductor material layer 58, for outputting a detection signal. Here, preferably, the first semiconductor material layer 51 is a p-type layer and the second semiconductor material layer 58 is an n-type layer.

The absorption layer 57, an intrinsic semiconductor layer, absorbs some of the light emitted to the upper surface of the first or second surface emitting laser 20 or 60 and monitors the light output. A feedback signal is transmitted to the driving circuit of the first and second surface emitting lasers 20 and 60 in accordance with the monitored light output signal so as to control the light output and signal level.

If the first and second photodetectors 50 and 70 are integrally formed on the upper surfaces of the first and second surface emitting lasers 20 and 60, the number of stacks of the first reflector layer 23 is made to be greater than that of the second reflector layer 27 to make the reflection coefficient of the first reflector layer 23 higher than that of the second reflector layer 27 so that most of the light is preferably emitted to the upper surfaces of the first and second surface emitting laser 20 and 60.

In the first and second transmitting/receiving modules 10 and 15 having the aforementioned configuration, signal transmission is achieved as follows. First, if a signal is intended to be transmitted from the first transmitting/receiving module 10 to the second transmitting/receiving module 15, the first surface emitting laser 20 is driven so that the modulated light containing an information signal is emitted.

The light emitted from the first surface emitting laser 20 is incident into the second photodetector 70 of the second transmitting/receiving module 15 to then be detected from the absorption layer 27. The detected signal is converted into a current signal and then restored into an original signal through an amplifier, etc.

Also, if a signal is intended to be transmitted from the second transmitting/receiving module 15 to the first transmitting/receiving module 10, signal transmission is achieved by the same principle.

According to embodiments of the present invention, the signal transmission from the first transmitting/receiving module 10 to the second transmitting/receiving module 15 and the signal transmission from the second transmitting/receiving module 15 to the first transmitting/receiving module 10 can both be achieved along a single path. Thus, one channel is enough for signal transmission between the first and second transmitting/receiving modules 10 and 15.

Preferably, as shown in Figure 4, the signal transmission between the first and second transmitting/receiving modules 10 and 15 is performed through an optical fibre 13 installed therebetween. The signal transmission from a second transmitting/receiving module 15 to a first transmitting/receiving module 10 is also achieved by the same procedure as described above.

Assuming that the absorption coefficient of the first or second photodetector 50 or 70 is α, the light output of the first or second surface emitting laser 20 or 60 is P, and the coupling coefficient of the optical fibre 13 is β, the amount of the light emitted from the first surface emitting laser 20 and having passed through the first photodetector 50 is P(1-α). Thus, the amount of the light having passed through the optical fibre 13 and incident and absorbed into the second photodetector 70 is Pβ(1-α)α. The amount of light having been transmitted through the second photodetector 70 is Pβ(1-α)².

Here, since the reflection coefficient of the second reflector layer 27 of the second surface emitting laser 60 is approximately 1, the light having been transmitted through the second photodetector 70 is totally reflected at the second reflector layer 27 and absorbed at the second photodetector 70. Thus, the amount of the light detected by the second photodetector 70 is Pβ(1-α)(2-α) which is the sum of the amount of initially absorbed light, that is, Pβ(1-α)α, and the amount of absorbed after being reflected from the second reflector layer 27, that is, Pβ(1-α)²α.

Also, the amount of light detected by the first photodetector 50 of the first transmitting/receiving module 10 for monitoring the first surface emitting laser 20 is Pα and the magnitude of its output signal value is determined in accordance with the magnitude of the absorption coefficient α of the first photodetector 50. Here, in order to maximize the output signal value of a receiving module side, the absorption coefficient α of the first or second photodetector 50 or 70 is preferably about 0.4.

Here, if the signal transmission between the first and second transmitting/receiving modules 10 and 15 is achieved through a free space, instead of the optical fibre 13, the coupling coefficient β of the optical fibre 13 is set to 1.

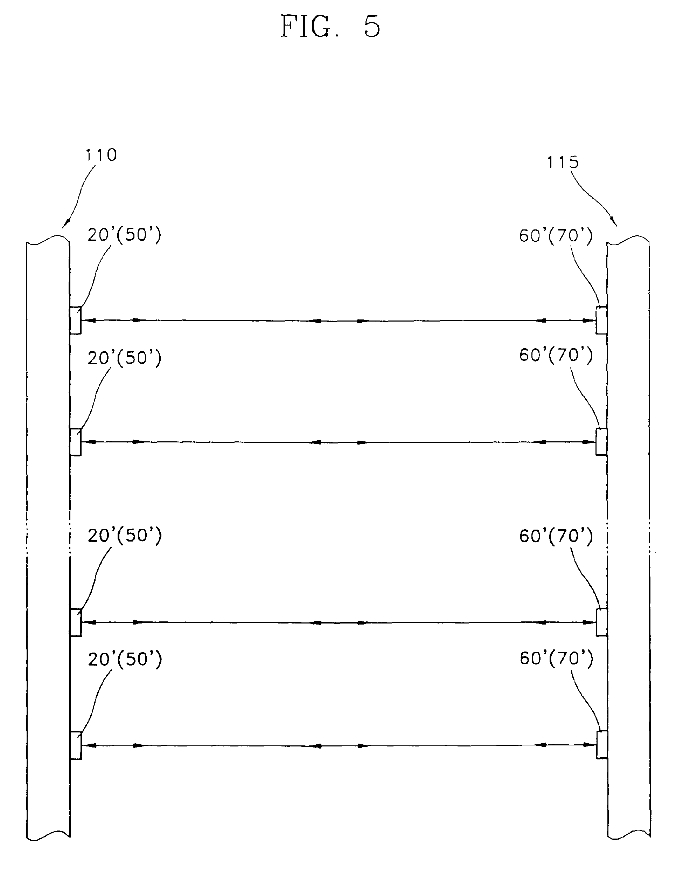

Figure 5 schematically illustrates a light transmitting/receiving module system according to another embodiment of the present invention. Referring to the drawing, the light transmitting/receiving module system according to this embodiment includes a first transmitting/receiving module 110 having a plurality of first surface emitting lasers 20' and a plurality of first photodetectors 50' integrally formed on the first surface emitting lasers 20', and a second transmitting/receiving module 115 having a plurality of second surface emitting lasers 60' and a plurality of second photodetectors 70' integrally formed on the second surface emitting lasers 60'.

Since the first and second surface emitting lasers 20' and 60' emit light in a direction in which the semiconductor material layers are stacked, they can be arranged in an array format on a single substrate (22 of Figure 3).

Here, the construction of the first and second surface emitting lasers 20' and 60' is the same as that of the first embodiment illustrated in FIGs. 2 and 3.

In the light transmitting/receiving module system this embodiment, the signal transmission between the first and second transmitting/receiving modules 110 and 115 can be achieved through a plurality of channels.

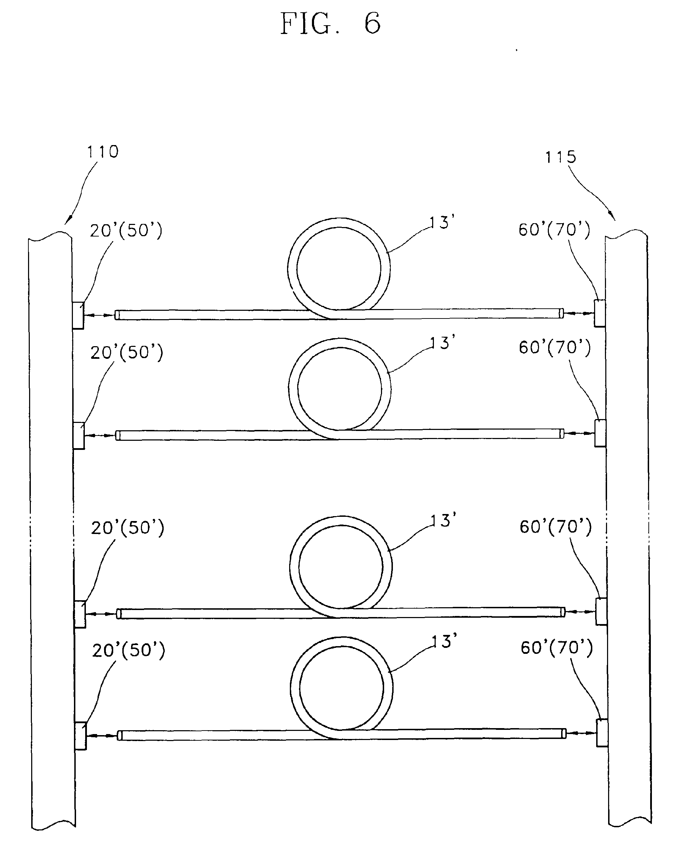

Preferably, the signal transmission between the first and second transmitting/receiving modules 110 and 115 is achieved through an optical fibre 13' installed therebetween, as shown in Figure 6.

In the light transmitting/receiving module system using surface emitting lasers according to embodiments of the present invention, a surface emitting laser with a photodetector integrally formed thereon is employed and the signal transmitting/receiving is achieved through a single path, the system structure is simplified and the number of necessary components is reduced. Further, even in the case of the signal transmission through multiple channels, the module system becomes less bulky.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A light transmitting/receiving module system comprising:
a first transmitting/receiving module (10) having a first surface emitting laser (20) for emitting light in a direction in which semiconductor material layers are stacked and a first photodetector (50) integrally formed on the first surface emitting laser (20); and
a second transmitting/receiving module (15) having a second surface emitting laser (60) for emitting light in a direction in which semiconductor material layers are stacked and a second photodetector (70) integrally formed on the second surface emitting laser (60),
wherein a first light emitted from the first surface emitting laser (20) is detected by the second photodetector (70) and a second light emitted from the second surface emitting laser (60) is detected by the first photodetector (50) so that the first and second lights are transmitted through a single path.

2. The light transmitting/receiving module system according to claim 1, wherein the first (50) and second (70) photodetectors monitor the amount of the light emitted from the first (20) and second (60) surface emitting lasers.

3. The light transmitting/receiving module system according to claim 1 or 2, wherein each of the first (20) and second (60) surface emitting lasers comprises:
a substrate (22);
a first reflector layer (23) formed on the upper surface of the substrate (22);
an active layer (25) formed on the upper surface of the first reflector layer (23), for generating light;
a second reflector layer (27) formed on the upper surface of the active layer (25), for reflecting the light generated at the active layer (25) to resonate the light together with the first reflector layer (23); and
first and second electrodes (21, 30) formed on the lower surface of the substrate (22) and on a part of the upper surface of the second reflector layer (27).

4. The light transmitting/receiving module system according to claim 3, wherein each of the first and second surface photodetectors (50, 70) comprises:
a first semiconductor material layer (51) stacked on the second reflector layer (27);
an absorption layer (57) stacked on the first semiconductor material layer (51), for absorbing incident light;
a second semiconductor material layer (58) stacked on the absorption layer (57); and
a third electrode (59) formed on a part of the upper surface of the second semiconductor material layer (58), for outputting a detection signal.

5. The light transmitting/receiving module system according to claim 1, 2, 3 or 4, further comprising an optical fibre (13) installed along an optical path between the first and second transmitting/receiving modules (10, 15), for transmitting light.

6. A light transmitting/receiving module system comprising:
a plurality (110) of first transmitting/receiving modules each having a first surface emitting laser (20') for emitting light in a direction in which semiconductor material layers are stacked and a first photodetector (50') integrally formed on the first surface emitting laser (20'); and
a plurality (115) of second transmitting/receiving modules each having a second surface emitting laser (60') for emitting light in a direction in which semiconductor material layers are stacked and a second photodetector (70') integrally formed on the second surface emitting laser (60'),
wherein a first light emitted from the first surface emitting laser (20') is detected by the second photodetector (70') and a second light emitted from the second surface emitting laser (60') is detected by the first photodetector (50') so that the first and second lights are transmitted through a single path.

7. The light transmitting/receiving module system according to claim 6, wherein the first and second surface emitting lasers (20', 60') of the plurality of the first and second transmitting/receiving modules (110, 115) are integrally formed on a single substrate (22) in an array format.

8. The light transmitting/receiving module system according to claim 6 or 7, wherein the first and second photodetectors (50' 70') monitor the amount of the light emitted from the first and second surface emitting lasers (20', 60').

9. The light transmitting/receiving module system according to claim 6, 7 or 8, wherein each of the first and second surface emitting lasers (20', 60') comprises:
a substrate (22);
a first reflector layer (23) formed on the upper surface of the substrate (22);
an active layer (25) formed on the upper surface of the first reflector layer (23), for generating light;
a second reflector layer (27) formed on the upper surface of the active layer (25), for reflecting the light generated at the active layer (25) to resonate the light together with the first reflector layer (23); and
first and second electrodes (21, 30) formed on the lower surface of the substrate (22) and on a part of the upper surface of the second reflector layer (27).

10. The light transmitting/receiving module system according to claim 9, wherein each of the first and second surface photodetectors (50', 70') comprises:
a first semiconductor material layer (51) stacked on the second reflector layer (27);
an absorption layer (57) stacked on the first semiconductor material layer (51), for absorbing incident light;
a second semiconductor material layer (58) stacked on the absorption layer (57); and
a third electrode (59) formed on a part of the upper surface of the second semiconductor material layer (58), for outputting a detection signal.

11. The light transmitting/receiving module system according to claim 6, 7, 8, 9 or 10, further comprising a plurality of optical fibres (13') installed along an optical path between the first and second transmitting/receiving modules (110, 115), for transmitting light.
